Europäisches Patentamt

European Patent Office

Office européen des brevets

(11) Publication number: **0 471 938 A1**

# EUROPEAN PATENT APPLICATION

(21) Application number: **91109813.5**

(22) Date of filing: **14.06.91**

(51) Int. Cl.⁵: **H01L  23/14**, H01L 25/16, H01L 23/50

(30) Priority: **23.07.90 US 556156**

(43) Date of publication of application:
**26.02.92 Bulletin  92/09**

(84) Designated Contracting States:
**DE FR GB IT**

(71) Applicant: **International Business Machines Corporation**
**Old Orchard Road**
**Armonk, N.Y. 10504(US)**

(72) Inventor: **Lauffer, John Matthew**
**R.D. No. 1**
**Waverly, New York 14892(US)**
Inventor: **Schumacher, Richard Anthony**
**53 Coventry Road**
**Endicott, New York 13760(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

(54) **High circuit density thermal carrier.**

(57) A microelectronic package having electrically conductive structures, e.g., power core means (11), and signal core means (15, 18), and thermal conduction means, where the thermal conduction means are part of the electrically active structure of the package, are electrically and thermally in series with the integrated circuit, and are integral to the microelectronic package. As used herein the electrically conductive structure includes the power core means (i.e., power supply core means and ground (22, 25) core means) and the signal core means. That is, as used herein, the power core means includes separate power supply core means for powering an integrated circuit (5) and ground core means for grounding the integrated circuit, and the signal core means includes circuitized means for carrying signals to and from the integrated circuit.

FIG. 4

This invention relates to electronic circuit packages, for example, cards and boards, having thermal management structures and internal electrical cores and planes. More specifically the invention relates to circuit packages having electrically and structurally integral heat dissipation means. In a preferred embodiment an electronic circuit package, such as an organic circuit package having polyimide or epoxy impregnated glass cloth structural members, is provided having at least power core means (power supply core means and ground core means), and signal core means, where one of the power core means, that is, either or both of the power supply core means or the ground core means, is of sufficient thermal mass to be an element of the package level thermal management, such as a thermal conductor and/or a heat sink.

The general structures and manufacturing processes for electronic packages are described in, for example, Donald P. Seraphin, Ronald Lasky, and Che-Yo Li, Principles of Electronic Packaging, McGraw-Hill Book Company, New York, New York, (1988), and Rao R. Tummala and Eugene J. Rymaszewski, Microelectronic Packaging Handbook, Van Nostrand Reinhold, New York, New York (1988).

An electronic circuit may contain many electronic circuit components, e.g., thousands or even millions of individual resistors, capacitors, inductors, diodes, and transistors. These individual circuit components must be interconnected to form the circuits, and the individual circuits must be interconnected to form functional units. Power and signal distribution are done through these interconnections. The individual functional units require mechanical support and structural protection. The electrical circuits require electrical energy to function, and the removal of thermal energy to remain functional. Microelectronic packages, for example, chips, modules, circuit cards, and circuit boards, are used to protect, house, cool, and interconnect circuit components and circuits.

Within an integrated circuit, circuit component to circuit component and circuit to circuit interconnection, heat dissipation, and mechanical protection are provided by an integrated circuit chip. This chip enclosed within its module is referred to as the first level of packaging.

There is at least one further level of packaging. This second level of packaging is the circuit card. The circuit card is necessary for at least four functions. First, the circuit card is employed because the total required circuit or bit count to perform a desired function exceeds the bit count of the first level package, i.e., the chip. Second, the second level package, i.e., the circuit card, provides a site for components that are not readily integrated into the first level package, i.e., the chip or module. These components include capacitors, precision resistors, inductors, electromechanical switches, optical couplers, and the like. Third, the circuit card provides for signal interconnection with other circuit elements. Fourth, the second level package provides for thermal management, i.e., heat dissipation.

In most applications there is a third level of packaging. This is the board level package. The board contains connectors to accept a plurality of cards, and provide communication between the cards.

Increasing logic densities accompanied by increasing circuit densities impose higher thermal loads on electronic packages. F.E. Andros and B.G. Sammakia, Thermal Management in Electronic Packaging, in Seraphim. Lasky, and Li, Principles of Electronic Packaging, at page 127, state that to achieve improved performance in data processing equipment, trends in electronic packaging designs have moved toward larger circuit chips, higher I/O density, increased circuit density, and increased reliability. These increases in chip size, I/O density, circuit density, and reliability have brought about improved performance by, among other things, reducing electrical line lengths and point to point flight times. Simultaneously, these improvements have significantly increased power density. For example, Antonetti, Oktay, and Simons, Heat Transfer In Electronic Packages, in Tummala & Rymaszewski, Microelectronics Packaging Handbook, page 167, report a 5 millimeter by 5 millimeter chip has a thermal flux of 10 Watts, for a total heat flux of 400 Kilowatts per square meter.

The very rapid increases in chip and package level power demands and thermal loads have occurred in the face of rapidly decreasing individual device power demands. This increase in chip level power demand is because of even more rapidly increasing device densities and degrees of integration. When solid state devices were first introduced, it was surmised that solid state devices, with their low individual power requirements relative to vacuum tubes, would minimize if not eliminate thermal management concerns. This has not been the case, as the packing densities, and concomitantly the power densities, of integrated circuits have increased dramatically over the years. For example, while CMOS devices have lower power demands per device then, for example, bipolar devices, the number of CMOS devices per modern CMOS integrated circuit is orders of magnitude higher than the number of bipolar devices per older bipolar integrated circuit.

Meanwhile, package design, that is, card and board design, have been driven by the necessity of accommodating the above described ever increasing density of logic or memory, with their concomitant increase in interconnections, in a smaller area. As noted by Andros and Sammakia, these high density cards and boards have high power density, and therefore require sophisticated thermal management.

Package level thermal management is particularly important because integrated circuit failure rates increase by a factor of two for every 10° Centigrade increase in operating temperature. Andros and Sammakia point out that reliability at all levels of packaging is directly related to temperature. For example, higher operating temperatures accelerate failure mechanisms, such as creep, corrosion, and electromigration. Likewise, Andros and Sammakia point out that the temperature differences which occur as a system is cycled between power-off and power-on states have a significant effect on electronic component reliability, due mainly to fatigue in composite structures formed of materials with differing coefficients of thermal expansion.

Antonetti, Oktay, and Simons state that it is a requirement that the thermal management of the electronic package satisfy some or all of the performance criteria:

* Integrated circuit device temperatures must be maintained below maximum allowable limits at "worst case" operating conditions (that is, worst-case values of device and module power and thermal resistances, coolant flow rates, environmental conditions, etc.)
* Integrated circuit device temperatures experienced during normal operating conditions must allow reliability goals to be achieved.
* Temperature variations of devices belonging to the same signal network must be maintained within allowable limits.
* The reliability of the thermal management scheme must be acceptable.
* Electronic noise limitations must be met.

The purpose of any thermal management design is to attain these ends by allowing the flow of thermal energy from the heat source, i.e., the integrated circuit chip, to the heat sink, i.e., the external environment, within the constraints of specified temperatures and thermal fluxes. Ideally, this is accomplished by combinations of conduction and convection, e.g., natural and forced convection.

Various designs to accomplish one or more of these ends are enumerated and described in Vincent A. Antonetti and Robert E. Simons, Bibliography of Heat Transfer In Electronic Equipment, **IEEE Trans. Components, Hybrids, and Manuf. Techn., CHMT-8(2)**, pp. 289-295 (June 1985). The intra-package heat transfer structures described in the papers enumerated by Antonetti and Simons are characterized by a high thermal conductivity body portion to perform the heat transfer function. However, this high thermal conductivity body portion is electrically insulated from the integrated circuit chips.

The electrical isolation of the heat transfer body portion from the circuitry is also common to the structures described in the patent literature. For example, U.S. Patent 4,866,501 describes a silicon wafer having an integrated circuit chip bonded within a recess on one surface of the wafer, and a "support" (14) bonded to the opposite surface of the wafer. Shanefield discloses that the "support" may be either a heat sink or a conducting plane, e.g., a ground plane.

U.S. Patent 4,860,165 describes an electronic package where the heat sink (28) is thermally in contact with but electrically insulated from an integrated circuit chip (20).

U.S. Patent 4,700,273 describes an electronic package where the heat sink (10) is thermally in contact with but electrically insulated from an integrated circuit chip (2) through a ceramic substrate (8).

U.S. Patent 4,459,607 also describes an electronic package where the heat sink (30) is thermally in contact with but electrically insulated from an integrated circuit chip (10) through a multilayer substrate (16-28-30).

U.S. Patent 4,703,339 also describes an electronic package where the heat sink (10, 10a) is thermally in contact with but electrically insulated from an integrated circuit chip (6) through a ceramic substrate (1).

U.S. Patent 4,585,706 describes a package where an integrated circuit chip (11) is mounted on a thermally conductive but electrically insulating, sintered aluminum nitride substrate.

U.S. Patent 4,602,314 discloses a structure where a a Cu or Al (30) encased core (26) is used to conduct heat from an integrated circuit chip (32) to a heat sink (40). The heat sink (4) is separated from the printed circuit board (12), and the Cu or Al cladding (30) is separate from the leads (14).

U.S. Patent 4,782,893 discloses an electrically insulating, thermally conducting chip mounting pad.

U.S. Patent 4,750,089 describes an electronic package where the thermal connection from chip to pad and the electrical connection from chip to pad follow separate paths.

U.S. Patent 4,835,344 describes a pin structure where the pin is in contact with an electrically insulating, thermally enhanced ceramic, and a conductor.

Package level thermal management for high circuit density multilayer microelectronic packages requires a simple and reliable structure that is effective and economical. A clear need exists for a simple package structure incorporating thermal management, and for a fabrication method that provides the ability to obtain high integral thermal conductivity while preserving the structural, thermal, and electrical integrity of the package.

Thus, the problem to be solved by the invention is to remove heat sink elements from the external surface of the package, thereby increasing the fraction of surface area of the package available for active circuit (logic and/or memory) chips and modules, and increasing the packing density of the package.

According to the invention as claimed and disclosed herein the problems of the prior art are obviated and the above objects are achieved by a microelectronic package having electrically conductive structures, e.g., power core means, and signal core means, and thermal conduction means, where the thermal conduction means are part of the electrically active structure of the package, are electrically and thermally in series with the integrated circuit, and are integral to the microelectronic package. As used herein the electrically conductive structure includes the power core means (i.e., power supply core means and ground core means) and the signal core means. That is, as used herein, the power core means includes separate power supply core means for powering an integrated circuit and ground core means for grounding the integrated circuit, and the signal core means includes circuitized means for carrying signals to and from the integrated circuit.

In the invention disclosed herein the power core means, i.e, the power supply core (conventionally designated $V_{cc}$ or $V_{dd}$), and the ground core (conventionally designated $V_g$), are an integral part of the electronic package thermal management structure. That is, the thermal conduction means comprise the power core means as an integral part thereof.

The utilization of the power core means as an integral part of the package thermal management structure requires that the thermal mass and the thermal conductivity of the power core means be high. Thus, in the microelectronic package herein contemplated the power core means is a thick plate power core, fabricated of a material having high electrical conductivity, high thermal conductivity, and high specific heat. Exemplary materials are Al and the metals of Group IB of the Periodic Table (Cu, Ag, and Au). Particularly preferred is a thick Al or Cu plate, i.e., an Al or Cu plate at least about 1 millimeter thick.

According to a preferred exemplification of the invention, a first electrically conductive plane, as a signal plane or core, or a power plane or core, including a power supply plane or core or a ground plane or core or both, is sized to have the thermal mass, either alone or in combination with other elements of the package, to heat sink the electronic circuit package.

According to the disclosed invention the conductive elements, e.g., the signal cores or planes, and the power cores or planes, including the ground cores or planes, are formed of materials having a high electrical conductivity (e.g., at least above $3\times10^5$ $(\text{ohm-cm})^{-1}$), a high thermal conductivity (e.g., at least above about 1.25 J/sec-deg C-cm), and a high specific heat (at least above about 0.02 cal/deg C-gm). Most commonly the conductive elements are formed of metallic conductors, as thick film metallic conductors, or metallic foil conductors, i.e., thermally and electrically conductive metallic structures that are at least about 1 millimeter thick. Generally, as noted hereinabove, the conductors, as the signal cores, and the ground and power supply cores, are metallic, and the metallic conductor is most commonly chosen from the group consisting of Al and the metals of Group IB of the Periodic Chart (Cu, Ag, and Au). Especially preferred is Cu.

Typically the dielectric is a low dielectric constant polymeric material, such as a glass fiber or cloth reinforced polymer, or a polymeric fiber or cloth reinforced polymer. In a particularly preferred exemplification of the invention the dielectric is a thermally enhanced dielectric polymeric material. Thermally enhanced polymeric dielectric materials are glass or polymer reinforced polymeric materials with a high thermal conductivity additive impregnated therein and dispersed therethrough. Exemplary high thermal conductivity additives include, by way of illustration and exemplification, and not limitation, zinc oxide, aluminum oxide, and aluminum nitride.

It is one advantage of the invention to provide a simple electronic package fabrication method including the fabrication of integral heat sink means.

It is a further advantage of the invention to obtain high levels of integral heat sinking capability while preserving the structural, thermal, and electrical integrity of the electronic package.

It is a still further advantage of the invention to provide a thin film method of fabricating integral internal heat sink structures in an electronic package.

It is a further advantage of the invention to provide a microelectronic circuit package having thermal isolation for surface mounting of logic and memory integrated circuits on the same package.

It is a still further advantage of the invention to provide a microelectronic circuit package with buried impedance elements (as inductors, capacitors, and resistors) elements in close proximity to integral heat transfer means.

For a better understanding of the present invention, together with further objects and advantages, preferred embodiments of the invention are described in the following with reference to the accompanying drawings, in which:

FIG. 1    is a partial cutaway elevation of a second level package embodying one exemplification of the invention;

FIG. 2    is a partial cutaway elevation of a second level package fabricated by an alternative method of fabricating the package of the invention;

FIG. 3    is a partial cutaway elevation of a second level package fabricated by a further alternative method of fabricating the package of the invention; and

FIG. 4    is a partial cutaway elevation of a second level package of the invention depicting alternative means of chip attachment.

According to the invention disclosed herein there is provided a microelectronic package 1 having thermally effective power core means 11, signal carrying means 15, 18, and thermal conduction means, including, for example, thermally enhanced dielectric means 14. The thermal conduction means are electrically and thermally in series with the integrated circuit 5 and integral to the microelectronic package 1. As used herein, the power core means includes separate power supply core means for powering an integrated circuit and ground core means for grounding the integrated circuit.

According to a preferred exemplification of the invention, a conductive plane, for example a signal plane or core, or a power plane or core, including a ground plane or core, is sized to have the thermal mass, in combination with other elements of the package, to heat sink the electronic circuit package.

A vital part of the invention disclosed herein is the utilization of the power core means 11, i.e, the power supply core (conventionally designated $V_{cc}$ or $V_{dd}$), or the ground core (conventionally designated $V_g$), as an integral part of the package thermal management structure. That is, the thermal conduction means comprise the power core means as an integral part thereof.

The utilization of the power core means 11 as an integral part of the electronic package thermal management structure requires that the thermal mass and the thermal conductivity of the power core means 11 be high, especially relative to that of the dielectric 14. Thus, in the microelectronic package 1 herein contemplated the power core means 11 is a thick plate power core, e.g., an Al or Cu plate 11 at least about 1 millimeter thick.

According to the disclosed invention the conductive elements, e.g., the signal cores or planes 15, 18, and/or the power cores or planes 11, including the ground cores or planes, are formed of materials that have a high electrical conductivity, a high thermal conductivity, and a high specific heat as defined hereinabove. While these materials may be either metallic conductors or conductive polymers, most commonly they are metallic conductors, as thick film metallic conductors, or metallic foil conductors. When the conductors, as the signal cores, and the ground and power cores, are metallic, the metallic conductor is most commonly chosen from the group consisting of Al and the metals of Group IB of the Periodic Chart, Cu, Ag, and Au. Especially preferred is Cu. Cu is preferred because of its high electrical conductivity, high thermal conductivity, and high specific heat.

Typically the dielectric 14 may be a ceramic or a polymeric, as a glass or polymer reinforced polymeric dielectric. The structure and fabrication of reinforced polymeric dielectrics is known to a person skilled in the art and from Principles of Electronic Packaging, and Microelectronics Packaging Handbook.

In a particularly preferred exemplification of the invention the dielectric is a thermally enhanced polymeric dielectric material. Thermally enhanced dielectric materials are glass reinforced polymeric materials with a high thermal conductivity additive impregnated therein and dispersed therethrough. Epoxy compositions of enhanced thermal conductivity for use in preparing printed circuit boards are described in commonly assigned European Application 89 122 094.9 of Boyko et al for "Epoxy Composition of Increased Thermal Conductivity And Use Thereof," and also in commonly assigned U.S. Patent No. 4,960,634 of Boyko et al for "Epoxy Composition of Increased Thermal Conductivity And Use Thereof," the disclosures of which are both incorporated herein by reference.

The enhanced thermal conductivity compositions of Boyko et al. contain a thermally effective amount of zinc oxide, for example, about 40 to 75 parts by weight zinc oxide per 100 parts by weight resin solids. The zinc oxide powder can be present in various particle shapes, with spherical being the most readily available. The zinc oxide particle size is disclosed to be such that 100 percent passes a 44 micron screen.

Exemplary high thermal conductivity additives include, by way of illustration and exemplification, and not limitation, zinc oxide, aluminum oxide, and aluminum nitride. The additive is generally present in a concentration of from about 40 weight percent to about 75 weight percent, basis resin solids. A particularly preferred thermally enhanced dielectric is a glass or polytetrafluoroethylene reinforced polyimide or polyepoxide containing from about 40 to about 75 weight percent, and preferably from about 40 to about 60 weight percent of zinc oxide (basis: total polymer).

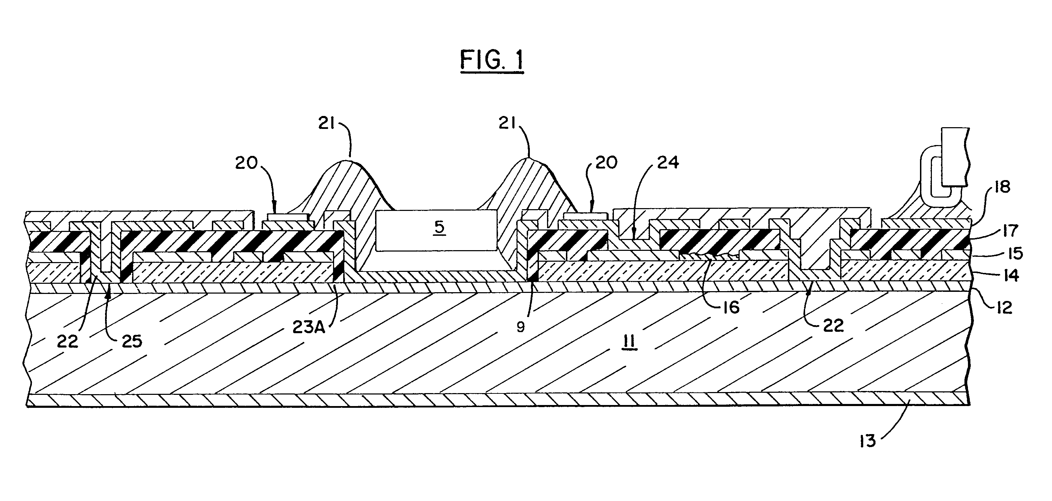

One particularly preferred exemplification of the invention is the circuit package shown in cutaway elevation view in FIG. 1. This exemplification, which is a second level package, i.e., a card, includes:

(a). A thick metal plate 11, e.g., Cu plate 11. Cu plate 11 is a thick plate, with a thickness great enough to be thermally effective as a heat sink and/or a thermal conductor. This is a thickness of at least about 1 millimeter.

(b). When the metal plate is Al, the metal plate includes Cu layers 12, 13. These layers, which may be sputtered, electrolessly deposited, or electrolytically deposited provide back bonding capability for the chip 5, and enhanced radiative heat transfer on the bottom.

(c). Further surface treatments, not shown, of the Cu plate increase laminate adhesion on the top.

(d). A thermally enhanced dielectric 14, as described hereinabove and hereinbelow is laminated to the Cu surface 12 of the plate 11. Additionally, a conductor/resistor layer 15 may be laminated to the dielectric 14.

(e). Conductive lines may be subtractively etched in layer 15. Alternatively the conductor/resistor layer 15 may be additively applied to the dielectric layer 14. Further processing allows the formation of buried resistors and buried capacitors.

(f). The thermally enhanced dielectric is then selectively drilled, for example laser drilled, to connect, e.g., conductor 15 to ground 22 and conductor 18 to ground 25.

(g). The thermally enhanced dielectric layer 14 may also be drilled, e.g., laser drilled, to provide a window 23A for direct back bond attach of the chip 5 to the metal carrier 11.

(h). A photosensitive dielectric 17, e.g., a solder mask material, may be coated, exposed, and developed, to provide, for example, (i) interconnects 24 between layer 15 and layer 18, (ii) chip windows 23A, (iii) isolation 22 for the interconnects between layer 18 and ground, and (iv) a window 9 for the chip 5 to ground interconnects.

(i). Portions of the photosensitive dielectric 17 may then be surface treated, and Cu plated, e.g., electrolessly plated or electrolytically plated, for example to provide pads, lands, and signal lines.

(j). Gold or nickel may then be selectively plated onto the pads or lands to to create wire bond pads 20 for chip interconnects 21.

(k). Thereafter conductor lines 18 and pads may be subtractively etched.

This structure offers the advantage of passive components, as the resistors and the combined heat sink and core 11 being buried in the card, thus freeing surface area for circuitization and surface mount. A further advantage is that high power chips 5 are directly mounted to the heat sinking metal core 11 for improved thermal and electrical performance. Moreover, the buried resistors 16 and capacitors (if any) are in close proximity to the heat sink 11, being separated therefrom by the thin, thermally enhanced dielectric layer 14, thus minimizing thermal effects of these components. This package also offers back side enhancement of radiative heat transfer, and at least two layers of wiring.

This structure results in high thermal conductivity, while preserving the structural, thermal, and electrical integrity of the electronic package.

It is, of course, to be understood that the microelectronic package of the invention can have copper plated thru holes and blind via interconnections, or that the package can have solder filled (non-plated) thru holes and via interconnections. This is illustrated in the exemplifications below.

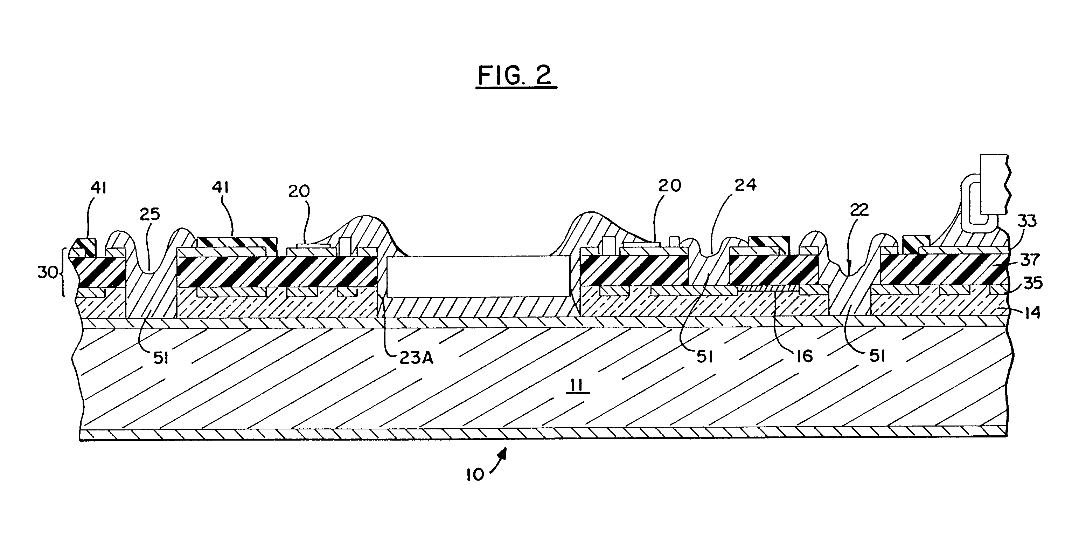

A second exemplification of the invention is shown in FIG. 2. The card there shown is fabricated by the following method.

(a). A core 30, as a signal/power core or a signal/signal core, is fabricated by laminating copper foil on the top 38 and bottom 35 surfaces of a thin, thermally enhanced, glass fiber reinforced dielectric material 37.

(b). The core 30 is then circuitized, for example by conventional photolithography and subtractive etch means, to form a plurality of signal lines and power bus lines on the top 38 and bottom 35 surfaces thereof.

(c). Surface mount device pads and interconnect lands are formed on the top surface of the core simultaneously with the circuitization step (b), above. Resistor and/or capacitor structures 16 may be formed on the bottom surface 35 of the core, for example by etching, or by screening of polymer thick film materials. In this way buried impedance (resistive, capacitive, and inductive) elements may be located in close proximity to a thick plate power core.

(d). Thereafter, pads, as Ni/Au plated pads 20, for wire bonding of chips, are formed, for example by conventional photolithography and electrolytic plating means. Alternatively, wire bond pads may be formed by electroless plating.

(e). The circuitized core 30 is then laminated to a thick heat sink/electrical conductor plate 11, i.e., a heat sink/ground plane. The plate may be a Cu plate, or a Cu treated Al plate. As noted above, this thick plate 11 serves as an integral heat sink and ground plane for the electronic package 10 of the invention. The circuitized core 30 is bonded to the thick heat sink/ground plane, for example with a thin, thermally enhanced dielectric material 14.

(f). Interconnection means, such as vias 22, 24, 25, between the two circuitized planes 35, 38 of the core, and between the core planes 35, 38 and the heat sink/ground plane, may be formed by $CO_2$ laser drilling of the dielectric material 37, 14. The $CO_2$ laser preferentially removes the dielectric material 37, 14 with only minimal thinning of the Cu circuitization layers 35, 38. Thus, the previously etched Cu patterns serve as a self aligning means for the laser drilling process. In a like manner, chip windows 23A for chip mounting directly to the ground plane 11 or to a buried signal layer or power layer are formed through laser drilling of the dielectric 14, 37.

(g). A protective coating layer 41, as a photoimageable or a screened layer, is then applied to the top surface of the electronic package 10.

(h). Final electrical interconnections of the laser drilled vias are made during surface mount assembly, where a solder paste (51) is screened into the vias, and reflowed thru vapor phase or infrared means.

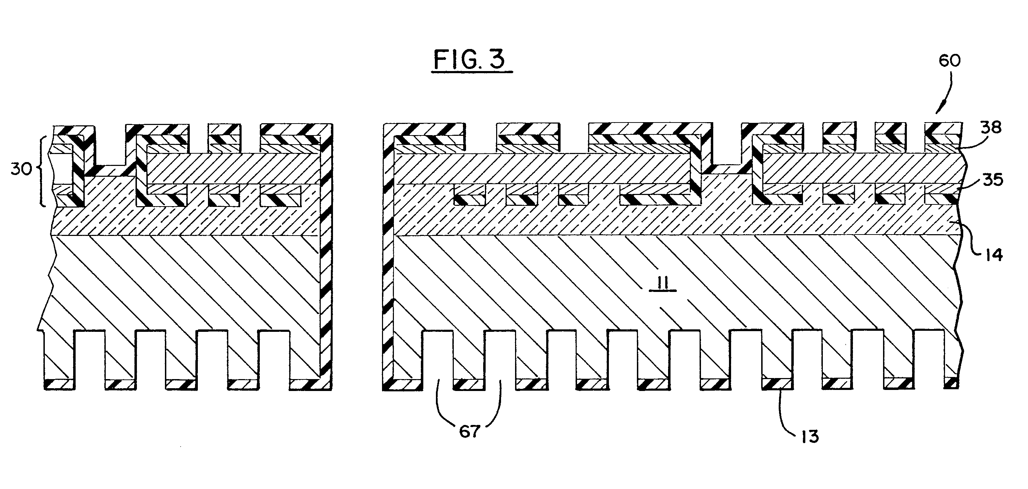

A third alternative exemplification of the invention provides for enhanced convective heat transfer from the heat sink/ground plane means. In this exemplification, shown in FIG. 3, enhanced heat transfer area is provided in the heat sink/ground plane 11. The package 60 of this third exemplification is prepared as follows:

(a). The core 30, i.e., the signal/signal core or the signal/power core, is laminated as described above. Thereafter the core 30 is drilled. The drilled holes formed thereby are seeded by an electroless copper process, and the entire core 30 is then electrolytically copper plated 65. This provides interconnections between the top 38 and bottom 35 surfaces of the core 30.

(b). The bottom surface 35 of the core 30 is then circuitized. Circuitization is typically carried out by a conventional photolithographic process with subtractive etching.

(c). The core 30 is then laminated to a thick heat sink/electrical conductor plate 11, i.e., a heat sink/ground plane. The plate may be a Cu plate, or a Cu treated Al plate. As noted above, this thick plate 11 serves as the integral heat sink and ground plane for the electronic package 60 of the invention. The circuitized core 30 is bonded to the thick heat sink/ground plane, for example with a thin, thermally enhanced dielectric material 14.

(d). The laminated structure 60 is mechanically drilled, electrolessly copper seeded, and electrolytically copper plated to provide electrical interconnection of the top surface, bottom surface or both top and bottom surfaces of the core with the ground plane.

(e). The top surface 38 of the package is then circuitized.

(f). According to a particularly preferred embodiment, the heat transfer area of the heat sink/ground plate 11 is enhanced. This may be accomplished by forming grooves 67 in the back surface 13 of the heat sink/ground plane 11. These grooves 67 may be formed by etching. Etching of the grooves is done simultaneously with the etching of the top surface of the package. The grooves 67 provide enhanced heat transfer area for convective heat transfer, for example by channeling air flow across the back side of the electronic package in a forced air flow environment, thus providing enhanced cooling means for the package.

The electronic packages fabricated as described above provide for a uniform temperature distribution throughout the entire structure.

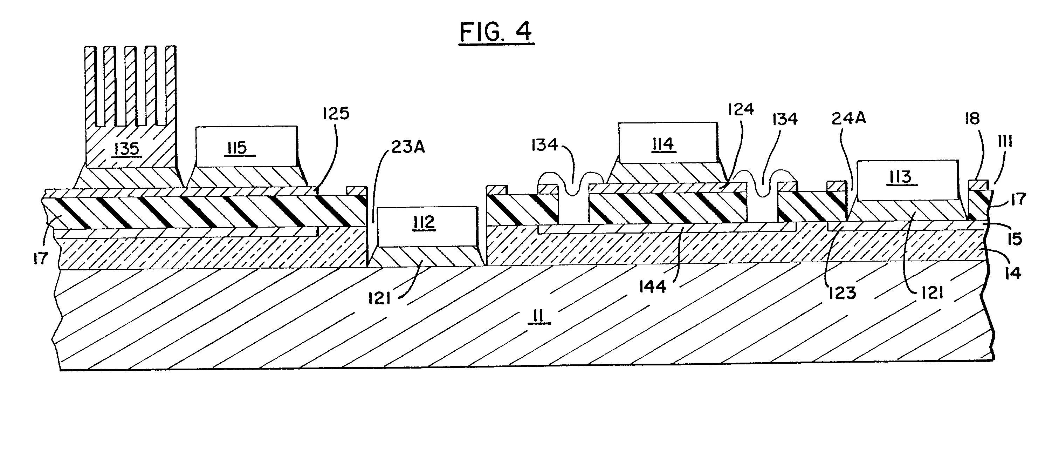

In a still further exemplification of the invention there is provided a package that integrates high power chips with low power chips on the same package. This feature is illustrated in FIG. 4, which shows various chip attach methods available to meet thermal, electrical, and reliability requirements. FIG. 4 depicts a second level package 111 fabricated by the method described with respect to FIG. 2.

(a). A first integrated circuit chip 112 having high power density and backside electrical potential at ground is attached directly to the heat sink/ground plane 11 by means of reflowed solder 121. The chip 112 is placed in a window 23A formed by $CO_2$ laser drilling of the dielectric layers 14,17. This packaging structure provides the maximum cooling potential for an integrated circuit chip 112. Due to the direct attachment and the high thermal conductivity of the heat sink/ground plane 11, a uniform temperature is maintained throughout the package.

(b). A second integrated circuit chip 113 having a high power density, but with a backside that is not at ground level, is attached directly to the buried signal and/or power layer 15 by means of a reflowed solder 121. The chip 113 is mounted in a window that was formed by $CO_2$ laser drilling of the dielectric layer 17. The chip 113 is further mounted on a large heat spreader pad 123 that was formed during circuitization of the buried layer. Heat is dissipated from this chip 113 through the backside solder and etched heat spreader and then conducted through the thin, thermally enhanced dielectric layer 14 to the heat sink/ground plane 11.

(c). A third method of mounting an integrated circuit chip 114 is by reflowing directly to the top surface 18 of the package. Thermal dissipation of this chip is provided by the solder filled blind vias 134 that connect a top surface heat spreader 124 with a buried layer heat spreader 144.

(d). A still further method of packaging low power logic and/or memory integrated circuit devices on the same carrier with power devices is illustrated with the fourth integrated circuit chip 115. Thermal isolation from other devices may be obtained by means of a standard, non-thermally enhanced dielectric material 17. Necessary cooling of this logic or memory device is provided by means of an etched heat spreader 125. Additional cooling of this device is provided by means of an optional surface mount heat sink 135.

The four chip attach methods illustrated in FIG. 4 all provide for the direct back bonding of the chip to the second level package with wire bond interconnections from the integrated circuit I/O's to the carrier. It is, of course, to be understood that other, alternative methods of interconnection may be utilized including, solely by way of example, and not limitation, TAB (tape automated bonding), plastic leaded chip carriers, and ceramic packages.

In these exemplifications the microelectronic circuit package has thermal isolation for surface mounting of logic and memory integrated circuits on the same package. More particularly, in these exemplifications, power chips capable of operating reliably at high temperatures, i.e., above about 110° Centigrade, may be integrated on the same package with memory and/or logic chips which must remain at lower temperatures, for example below about 75° Centigrade, for reliable operation. The thick heat sink/power plane provides cooling for the power chips while the logic and/or memory chips are cooled by the top surface heat spreader. Additional cooling for the low power logic and/or memory chips may be provided by the addition of surface mount heat sink means 135 contained on the heat spreader.

While the method and apparatus of the invention is described and illustrated with reference to copper conductive cores and planes, it is to be understood that the conductive elements may be formed of other metallic conductors. Most commonly the thermally active conductive cores and planes, useful as heat sinks and metallic conductors, are thick film metallic conductors, or metallic foil conductors. When the conductors, as the signal cores, the ground, and the power core provide a heat sink and/or thermal conductor function as contemplated herein, they typically have a thermally effective mass, and a thickness of at least about 1 millimeter.

**Claims**

1. A microelectronic package comprising:
   (a). combined power core (11) and thermal conduction means for powering and grounding an integrated circuit and carrying heat from said micro-electronic package and integrated circuit, said combined power core and thermal conduction means being formed of a thermally and electrically metal, and being thermally and electrically in series with said integrated circuit and integral to said microelectronic package; and
   (b). signal core means (15, 18) for carrying signals to and from the integrated circuit.

2. The microelectronic package of claim 1 wherein said combined power core and thermal conduction means is a thick plate combined power core and thermal conduction means.

3. The microelectronic package of claim 2 wherein said thick plate combined power core and thermal conduction means is at least 1 millimeter thick.

4. The microelectronic package of claim 2 comprising integrated circuit means, said thick plate combined power core and thermal conduction means, and dielectric means thermally therebetween.

5. The microelectronic package of claim 4 wherein said dielectric means is a polymeric material.

6. The microelectronic package of claim 4 wherein said dielectric means comprises thermally enhanced dielectric material, preferably fiber reinforced polymeric material having a high thermal conductivity additive, such as for example zinc oxide, aluminum oxide, and aluminum nitride.

7. The microelectronic package of any one of the preceding claims having copper plated thru hole and blind via interconnection means.

8. The microelectronic circuit package of claim 7 having non-plated, laser drilled and solder filled blind via interconnection means.

9. The microelectronic circuit package of claim 1 wherein said integrated circuit is a power integrated circuit, said power integrated circuit having direct backbonding thereof to said combined power core and thermal conduction means.

10. The microelectronic circuit package of claim 9 having thermal isolation for surface mounting of logic and memory integrated circuits on the same package.

11. The microelectronic circuit package of any one of the preceding claims comprising buried impedance elements in close proximity to a thick plate power core.

12. The microelectronic circuit package of any one of the preceding claims comprising:

a power integrated circuit chip being directly backbonded to said combined power core and thermal conduction means.

## FIG. 1

EP 0 471 938 A1

# FIG. 2

EP 0 471 938 A1

## FIG. 3

## FIG. 4

European
Patent Office

**EUROPEAN SEARCH
REPORT**

Application Number

**EP 91 10 9813**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | 31st ECC,IEEE,May11-13,1981,CH1671-7/81/0000- 0456, pp.456-464; J.R. GASKILL: "Kovar Large Area Hybrid Module" <br> * whole document* * | 1-3,5,7 | H 01 L 23/14 <br> H 01 L 25/16 <br> H 01 L 23/50 |
| | — — — | | |
| A | 1989 IEEE MTT-S IMSD,vol.1,June 13-15,1989, CH2725-0/89/0000-0937,pp.937-940; F.N. SECHI et al.:"Broadband Power Amplifiers Based on a New Monolithic Ceramic Technology" <br> * p.937,last paragraph* * | 1 | |
| | — — — | | |
| A | PATENT ABSTRACTS OF JAPAN vol. 11, no. 325 (E-551)(2772) 22 October 1987 <br> & JP-A-62 114 251 ( MATSUSHITA ELECTRIC WORKS LTD. ) <br> * abstract * * | 1-3,5,7-9, 12 | |
| | — — — | | |
| A | EP-A-0 219 627   (CONTRAVES AG) | | |
| | — — — | | |
| A | US-A-4 420 364   (SHARP KABUSHIKI KAISHA) | | |
| | — — — | | TECHNICAL FIELDS SEARCHED (Int. Cl.5) |
| P,X | EP-A-0 381 383   (KABUSHIKI KAISHA TOSHIBA) <br> * the whole document * * | 1-3,5 | H 01 L |
| | — — — — — | | |

The present search report has been drawn up for all claims

| Place of search | Date of completion of search | Examiner |
|---|---|---|
| The Hague | 28 November 91 | PROHASKA G.A.F. |